# EUROPÄISCHE PATENTSCHRIFT

(11) **EP 2 876 979 B1**
(45) Veröffentlichungstag und Bekanntmachung des Hinweises auf die Patenterteilung: **14.08.2019**
(21) Anmeldenummer: 14003954.6
(22) Anmeldetag: 24.11.2014
(51) Int. Cl.: H05K 1/02

(54) **LEITERPLATTE MIT KERAMIK-EINLAGEN**
CIRCUIT BOARD WITH CERAMIC INLAYS
CARTE DE CIRCUITS IMPRIMÉS AVEC INSERTS EN CÉRAMIQUE

(30) Priorität: 25.11.2013 DE 102013019617
(43) Veröffentlichungstag der Anmeldung: 27.05.2015
(73) Patentinhaber: Tesat Spacecom GmbH & Co. KG, 71522 Backnang (DE)
(72) Erfinder: Katz, Hanspeter, D-70374 Stuttgart (DE); Artmann, Jochen, D-71554 Weissach im Tal (DE); Wolf, Eric, D-71522 Backnang (DE); Rapp, Christian, D-71522 Backnang (DE); Köger, Ulrich, D-74405 Gaildorf (DE)
(74) Vertreter: LKGLOBAL Lorenz & Kopf PartG mbB Patentanwälte

(56) Entgegenhaltungen:
- EP-A2- 1 261 028
- EP-A2- 1 276 357
- CN-A- 102 625 563
- FR-A1- 2 984 679
- US-A1- 2007 284 711
- US-A1- 2009 301 765
- US-B1- 6 222 740

## Beschreibung

### Technisches Gebiet der Erfindung

Die Erfindung betrifft eine Leiterplatte, insbesondere eine mehrlagige elektrische Leiterplatte zum Aufnehmen von elektrischen Bauteilen, sowie eine elektrische Komponente mit einer solchen Leiterplatte.

### Hintergrund der Erfindung

Zur Realisierung von elektrischen Modulen oder Komponenten, welche im Rahmen von elektrischen oder elektronischen Baugruppen oder Vorrichtungen Verwendung finden, werden Leiterplatten mit elektrischen oder elektronischen Bauelementen bestückt. Dabei dienen die Leiterplatten der mechanischen Fixierung und der elektrischen Kopplung von auf einer Leiterplatte angeordneten Bauteilen. Die elektrischen Verbindungen werden mittels Leiterbahnen, beispielsweise Kupferleiterbahnen, hergestellt.

Als Leiterplattenmaterial wird üblicherweise ein Epoxid-Glas-Gemisch verwendet. Dabei kann eine Leiterplatte mehrlagig aufgebaut sein und mehrere Leiterbahnebenen bzw. Schichten aufweisen. Dadurch wird ermöglicht, dass jede Leiterbahnebene bzw. Schicht individuell mit elektrisch leitfähigen Leiterbahnen versehen wird, wodurch die Anzahl möglicher elektrischer Verbindungen zwischen den auf der Leiterplatte angeordneten Bauteilen erhöht werden kann.

Eine Leiterbahnebene bzw. Schicht kann eine Ausnehmung bzw. einen Durchbruch aufweisen, welcher das Herstellen einer elektrischen Verbindung zwischen Leiterbahnen auf unterschiedlichen Leiterbahnebenen ermöglicht, beispielsweise indem die Ausnehmung bzw. der Durchbruch mit elektrisch leitfähigem Material beschichtet wird oder ein elektrisch leitfähiges Material in der Ausnehmung bzw. dem Durchbruch angeordnet und elektrisch mit den zu verbindenden Leiterbahnen verbunden wird.

EP 0 926 929 A1 beschreibt eine Mehrlagen-Leiterplatte mit mehrere übereinander angeordneten durch Isolierstofflagen getrennten Leiterbahnebenen. Zwischen den äußeren Isolierstofflagen ist ein Kernsubstrat angeordnet, welches die Wärmeausdehnungseigenschaften der Mehrlagen-Leiterplatte an Wärmeausdehnungseigenschaften eines auf der Mehrlagen-Leiterplatte angeordneten Bauelementes anpasst. Das Kernsubstrat ist aus Molybdän gefertigt.

US 2007/0284711 A1 beschreibt eine mehrlagige Struktur mit einer ersten Lage, welche mit einem hitzeabgebenden Modul gekoppelt ist, einer zweiten Lage, welche mit einem Substrat verbunden ist, und einer dazwischen angeordneten mittleren Lage, welches eine Halbleiterkomponente und einen Wärmespreizer aufweist. Wärmeleitpfade erstrecken sich durch die erste und zweite Schicht in Richtung des Wärmespreizers, wobei einige der Wärmeleitpfade in der ersten Schicht das hitzeabgebende Modul kontaktieren.

US 2009/0301765 A1 beschreibt eine Leiterplatte mit zumindest einem Loch, in welchem ein wärmeabführendes Element angeordnet ist, wobei eine Strahlungsquelle in Form einer Leuchtdiode (LED) an dem wärmeabführenden Element angeordnet ist.

FR 2 984 679 A1 beschreibt eine metallische Einlage zur Verbesserung der Wärmeleitung zwischen einem elektronischen Bauelement und einem Kühlkörper.

### Zusammenfassung der Erfindung

Es kann als Aufgabe der vorliegenden Erfindung betrachtet werden, eine Leiterplatte anzugeben, welche sich durch eine hohe thermische Leitfähigkeit und durch eine verbesserte Hochspannungsisolierung auszeichnet.

Es sind eine Leiterplatte und eine elektrische Komponente gemäß den Merkmalen der unabhängigen Ansprüche angegeben. Weiterbildungen der Erfindung ergeben sich aus den abhängigen Ansprüchen sowie aus der folgenden Beschreibung.

Gemäß einem ersten Aspekt ist eine Leiterplatte für die Verwendung in Hochspannungsanlagen und im Vakuum angegeben, welche ausgeführt ist, mit elektrischen Bauelementen bestückt zu werden. Die Leiterplatte weist eine Mehrzahl von übereinander angeordneten Leiterbahnebenen auf, wobei jeweils zwei benachbarte Leiterbahnebenen durch eine Isolationslage gegeneinander isoliert sind. Die Leiterplatte ist dadurch gekennzeichnet, dass zwischen einer ersten äußeren Isolationslage und einer zweiten äußeren Isolationslage ein thermisch leitfähiges Element angeordnet ist, wobei das thermisch leitfähige Element Keramik aufweist und hochspannungsisolierend ausgeführt ist.

Der grundsätzliche geometrische Aufbau der Leiterplatte entspricht einer sog. Sandwich-Struktur, wobei sich in einer Tiefenrichtung der Leiterplatte elektrisch leitfähige Schichten, den Leiterbahnebenen, mit elektrisch isolierenden Schichten, den Isolationslagen, abwechseln.

Innerhalb der Leiterplatte, also in Tiefenrichtung zwischen einer ersten äußeren Isolationslage und einer zweiten äußeren Isolationslage, ist ein Kern angeordnet, welcher thermisch leitfähig ist und aus Keramik besteht.

Die elektrischen Bauelemente können dabei an der ersten äußeren Oberfläche angeordnet sein. Das thermisch leitfähige Element ermöglicht durch seine Eigenschaften und durch seine Anordnung innerhalb der Leiterplatte eine Wärmeleitung, insbesondere eine Wärmeableitung, von der ersten äußeren Oberfläche und den elektrischen Bauelementen zu der zweiten äußeren Oberfläche, welche beispielsweise der ersten äußeren Oberfläche gegenüberliegend oder auch quer dazu angeordnet ist.

Keramik eignet sich für die Verwendung als thermisch leitfähiges Element, da es neben guten Wärmeleiteigenschaften in der Regel auch eine gute Spannungsisolation, insbesondere eine Hochspannungsisolation ermöglicht und vorteilhafte mechanische Eigenschaften hinsichtlich seiner Steifigkeit aufweist.

Damit kann eine Leiterplatte wie oben und im Folgenden beschrieben insbesondere für Verwendungen in Hochspannungsanlagen und im Vakuum vorteilhaft sein. Ein solches Szenario ist beispielsweise im Einsatzgebiet von Satelliten, welche sich im luftleeren Raum befinden, gegeben.

Thermische Energie kann als Wärmefluss in einem Feststoff infolge eines Temperaturunterschieds (Wärmediffusion oder Konduktion) oder durch einen makroskopischen Materialstrom (Konvektion) von einer Wärmequelle in Richtung einer Wärmesenke abgeleitet werden. Daneben kann ein Wärmetransport auch durch Wärmestrahlung erfolgen.

Im luftleeren oder beinahe luftleeren Raum kann thermische Energie nicht mittels Konvektion übertragen werden, da beispielsweise ein Luftstrom zum Transport der Wärmeenergie nicht vorliegt. Damit kann beim Einsatz von technischen und/oder elektrischen Geräten im luftleeren Raum eine ggf. erforderliche Kühlung von elektrischen Bauelementen durch Konvektion nicht erfolgen. Eine Wärmeleitung im luftleeren Raum ist damit auf Konduktion und Wärmestrahlung beschränkt.

Keramik ist einerseits ein guter thermischer Leiter und bietet sich damit an, thermische Energie durch Konduktion zu transportieren. Andererseits erfüllt Keramik auch Anforderungen hinsichtlich der Hochspannungsisolation, so dass sich die Leiterplatte wie oben und im Folgenden beschrieben insbesondere für den Einsatz in einem Leistungsverstärker in Satelliten eignet.

Die Keramik des thermisch leitfähigen Elements kann insbesondere eine höhere thermische Leitfähigkeit aufweisen als das Material der Isolationslagen der Leiterplatte.

Gemäß einer Ausführungsform weist das thermisch leitfähige Element Aluminiumnitrid auf. Aluminiumnitrit zeichnet sich durch eine besonders gute thermische Leitfähigkeit aus.

Gemäß einer weiteren Ausführungsform ist das thermisch leitfähige Element elektrisch isolierend ausgeführt. In der Regel sind gute thermische Leiter auch elektrisch leitend. Bei Keramik ist insbesondere Letzteres in der Regel nicht der Fall und dieses Material stellt damit eine vorteilhafte Kombination guter thermischer Leitfähigkeit und elektrischer Isolation dar.

Gemäß einer weiteren Ausführungsform ist das thermisch leitfähige Element in einer Ausnehmung einer Isolationslage angeordnet.

Die Leiterplatte kann mehrlagig aufgebaut sein, wobei die Isolationslagen in Tiefenrichtung dicker sind als die Leiterbahnen. Wird in einer der inneren Isolationslagen eine Ausnehmung oder gar ein Durchbruch bereitgestellt, so kann das thermisch leitfähige Element als Kern der Leiterplatte angeordnet werden, ohne dass die Leiterplatte ihre nach außen sichtbaren geometrischen Ausmaße ändert. Weiterhin wird das thermisch leitfähige Element durch die Ausnehmung in seiner Position fixiert. Die Ausnehmung kann eine Vertiefung in einer Isolationslage oder ein Durchbruch durch eine Isolationslage sein.

Die Ausnehmung kann sich in Tiefenrichtung der Leiterplatte auch über mehr als eine Isolationslage erstrecken.

Gemäß einer weiteren Ausführungsform grenzt eine erste Oberfläche des thermisch leitfähigen Elementes in Tiefenrichtung (104) der Leiterplatte an eine erste Leiterbahnebene.

Da die erste Leiterbahnebene üblicherweise mit einem elektrisch leitfähigen Material versehen ist, weist diese auch eine hohe thermische Leitfähigkeit auf. Damit kann die thermische Energie von der ersten Oberfläche der Leiterplatte über die Leiterbahnen der Leiterbahnebene zu dem thermisch leitfähigen Element geleitet und durch letzteres weiter transportiert werden.

In einer Ausführungsform verlaufen Leiterbahnen der Leiterbahnebene auf bzw. entlang der ersten Oberfläche des thermisch leitfähigen Elementes.

Gemäß einer weiteren Ausführungsform grenzt eine zweite Oberfläche des thermisch leitfähigen Elementes in Tiefenrichtung der Leiterplatte an eine zweite Leiterbahnebene.

Hierfür gelten sinngemäß die gleichen Ausführungen wie für die erste Oberfläche des thermisch leitfähigen Elementes, insbesondere auch betreffend die Anordnung der Leiterbahnen der zweiten Leiterbahnebene mit Bezug zu der zweiten Oberfläche.

In anderen Worten kann also durch Leiterbahnen einer ersten Leiterbahnebene thermische Energie zu dem thermisch leitfähigen Element und durch Leiterbahnen einer zweiten Leiterbahnebene thermische Energie weg von dem thermisch leitfähigen Element geführt werden.

Gemäß einer weiteren Ausführungsform erstreckt sich das thermisch leitfähige Element in Tiefenrichtung der Leiterplatte über mehr als eine Isolationslage.

Gemäß einem weiteren Aspekt ist eine elektrische Komponente zur Verwendung in einem Satelliten angegeben. Die elektrische Komponente weist eine Leiterplatte wie oben und im Folgenden beschrieben und ein elektrisches Bauelement auf, welches mit einer Bestückungslage der Leiterplatte mechanisch und elektrisch gekoppelt ist. Das thermisch leitfähige Element ist dabei so angeordnet, dass es das elektrische Bauelement in Längsrichtung der Leiterplatte überlappt.

Die elektrische Komponente kann beispielsweise ein Leistungsverstärker für einen Satelliten sein, beispielsweise ein Leistungsverstärker in Form eines Wanderfeldröhrenverstärkers. Ein solcher besteht aus einer Wanderfeldröhre, die vornehmlich die HF Eigenschaften bestimmt und einer Stromversorgung, die die Versorgungsspannungen, vornehmlich Hochspannungen, erzeugt und eine Telemetrie- und Telekommando-Schnittstelle zu dem Satelliten darstellt.

Für die Erzeugung der für den Betrieb notwendigen Hochspannungen können in Serie geschaltete Gleichrichterstufen eingesetzt werden. Diese beinhalten verlustbehaftete Gleichrichterdioden, die ihrerseits durch die Serienschaltung gegenüber einer Wärmesenke, beispielsweise einem Gehäuse, hochspannungsisoliert sind. Durch das Fehlen von Luft oder einem anderen Umgebungsgas und damit der fehlenden Möglichkeit der Konvektionskühlung muss für Raumfahrtgeräte die anfallende Verlustleistung der elektrischen Bauelemente, also die überschüssige thermische Energie, über die Leiterplatte, also durch Konduktion, und über Wärmestrahlung abgeführt werden.

Überlappen bedeutet, dass eine senkrechte Projektion des elektrischen Bauelementes auf eine Oberfläche der Leiterplatte (als Projektionsfläche, bzw. auf die Längsrichtung beschränkt als Längsprojektion bezeichnet) einen Überlappungsbereich mit einer senkrechten Projektion des thermisch leitfähigen Elementes auf dieselbe Oberfläche der Leiterplatte aufweist.

Dabei kann das thermisch leitfähige Element das elektrisch leitfähige Bauelement zumindest teilweise, vollständig, oder genau überlappen. Eine vollständige Überlappung bedeutet, dass das thermisch leitfähige Element eine Längsprojektion aufweist, die größer ist als die Längsprojektion des elektrischen Bauelementes. Eine genaue Überlappung bedeutet, dass diese beiden Längsprojektionen identisch sind und sich ohne Überstand überlappen, also deckungsgleich sind. Bei einer teilweisen Überlappung können die Längsprojektionen identisch oder unterschiedlich sein und sind gegeneinander versetzt.

Gemäß einer Ausführungsform ist das thermisch leitfähige Element so angeordnet, dass es das elektrische Bauelement in Querrichtung der Leiterplatte überlappt.

Hierbei handelt es sich um eine Überlappung der Querprojektionen und es gelten die Ausführungen betreffend die Überlappung der Längsprojektionen sinngemäß, auch betreffend die teilweise, vollständige und genaue Überlappung.

Gemäß einer weiteren Ausführungsform weist die elektrische Komponente ein thermisches Kopplungselement auf, welches mit einer Außenlage der Leiterplatte thermisch gekoppelt ist und ausgeführt ist, Wärme von der Leiterplatte abzuführen, wobei das thermisch leitfähige Element so angeordnet ist, dass es das thermische Kopplungselement in Längsrichtung der Leiterplatte überlappt.

Die Außenlage ist der Bestückungslage gegenüberliegend angeordnet. Damit erfolgt ein thermischer Fluss von dem elektrischen Bauelement über die Bestückungslage, das thermisch leitende Elemente, die Außenlage und das thermische Kopplungselement.

Das thermische Kopplungselement ist ausgeführt, beispielsweise mit einem Gehäuse der elektrischen Komponente elektrisch, mechanisch und thermisch gekoppelt zu werden.

Betreffend die Überlappung des thermisch leitenden Elements und des thermischen Kopplungselements gelten die Ausführungen hinsichtlich der Überlappung der Längs- und Querprojektionen des elektrischen Bauelements und des thermisch leitenden Elements sinngemäß gleich.

Nachfolgend wird anhand der beigefügten Zeichnungen näher auf Ausführungsbeispiele der Erfindung eingegangen. Es zeigen:
- **Fig. 1**: Eine schematische Darstellung eines Querschnitts einer Leiterplatte gemäß einem Ausführungsbeispiel.
- **Fig. 2**: Eine schematische Darstellung eines Querschnitts einer Leiterplatte gemäß einem weiteren Ausführungsbeispiel.

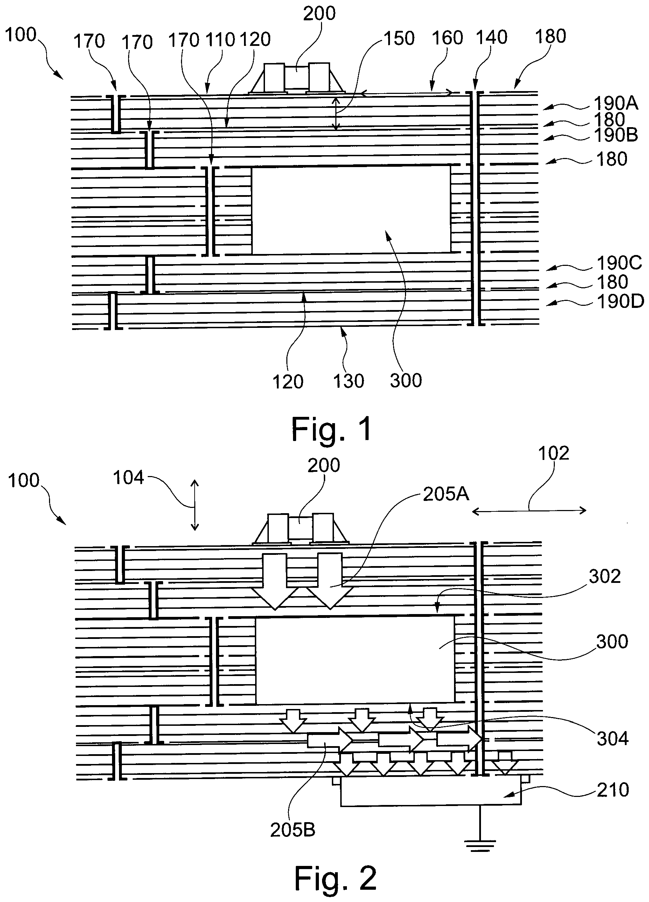

Fig. 1 zeigt eine geschichtet aufgebaute Leiterplatte 100 mit einer Mehrzahl von Leiterbahnebenen 180, welche als elektrisch leitfähige Schicht, beispielsweise aus Kupfer oder Kupferfolien, ausgeführt ist. Zwischen jeweils zwei in Tiefenrichtung der Leiterplatte benachbarten Leiterbahnebenen 180 ist jeweils eine Isolationslage 190A, 190B, 190C, 190D angeordnet.

Die elektrische Verbindung zwischen benachbarten Leiterbahnebenen kann beispielsweise durch eine Lagenverbindung 170 hergestellt werden, welche sich in Tiefenrichtung der Leiterplatte 100 zwischen Leiterbahnebenen erstrecken.

Ein elektrisches Bauelement 200 ist mit der Bestückungslage 110 gekoppelt. Eine Innenlage 120 weist einen Lagenabstand 150 zu der Bestückungslage auf. Der Lagenabstand 150 entspricht der Dicke einer Isolationslage 190A.

Das elektrische Bauelement 200 weist einen lateral verlaufenden Isolationsabstand 160 zu einer Befestigungshülse 140 der Leiterplatte auf.

Auf einer der Bestückungslage 110 gegenüberliegend angeordneten Oberfläche der Leiterplatte 100 ist eine Außenlage 130 angeordnet.

In dem gezeigten Ausführungsbeispiel weist die Leiterplatte 100 sechs Isolationslagen auf. In den beiden in Tiefenrichtung mittig angeordneten Isolationslagen ist eine Ausnehmung angeordnet, in der sich das thermisch leitfähige Element 300 befindet.

Das thermisch leitfähige Element 300 erstreckt sich in Tiefenrichtung der Leiterplatte 100 über zwei Isolationslagen.

Fig. 2 zeigt den Wärmefluss in einer Leiterplatte 100 von dem elektrischen Bauelement 200 über die Leiterplatte 100 und das thermisch leitende Element 300 zu einem thermischen Kopplungselement 210.

Die Längsrichtung 102 der Leiterplatte 100 verläuft in der Zeichenebene der Fig. 2 von links nach rechts. Eine Projektion des thermisch leitfähigen Elementes 300 auf die Bestückungslage überlappt in Längsrichtung eine Projektion des elektrischen Bauelementes 200 auf die Bestückungslage. Gleiches gilt für die Projektionen des thermisch leitenden Elementes 300 und des thermischen Kopplungselementes 210 auf die Außenlage 130.

Die Tiefenrichtung 104 der Leiterplatte 100 verläuft in der Zeichenebene der Fig. 2 von oben nach unten. Der Wärmefluss 205A, 205B ist durch Pfeile angedeutet.

Die Querrichtung der Leiterplatte verläuft senkrecht zu der Tiefenrichtung und zu der Längsrichtung, also in die Zeichenebene der Fig. 2 hinein.

Eine erste Oberfläche 302 und eine zweite Oberfläche 304 des thermisch leitfähigen Elementes 300 grenzen jeweils an eine Leiterbahnebene zwischen zwei benachbarten Isolationslagen.

In anderen Worten kann der Wärmefluss 205A, 205B wie folgt beschrieben werden: Die durch die Verlustleistung eines verlustbehafteten, hochspannungsbetriebenen Bauelementes 200 emittierte Wärme kann über die Bestückungslage 110 und Innenlage 120 und über die Isolationslagen in den Keramikkern 300 eingeleitet werden. Durch Variieren der Dicken von die Leiterbahnen bildenden Kupferfolien kann eine vorteilhafte Spreizung der emittierten Wärme gesteuert werden. Der Keramikkern leitet die Wärme zu der nächsten spreizenden Kupferfolie, d.h. zu der zweiten Oberfläche 304, und zu dem thermischen Kopplungselement 210, ohne dass dabei eine vorgegebene Hochspannungsbelastung bzw. Feldstärkedauerbelastung überschritten wird. Durch Berücksichtigung der Kriechstreckenanforderungen auf der Oberfläche und eines damit verbundenen Isolationsabstandes 160 sowie der Intralayerabstände 150 kann ein Spannungsüberschlag zwischen Bauelement 200 und mechanisch/thermischer Anbindung 140 verhindert werden.

## Patentansprüche

1. Leiterplatte (100) für die Verwendung in Hochspannungsanlagen und im Vakuum, welche ausgeführt ist, mit elektrischen Bauelementen (200) bestückt zu werden, die Leiterplatte aufweisend:
eine Mehrzahl von übereinander angeordneten Leiterbahnebenen (110, 120, 130);
wobei jeweils zwei benachbarte Leiterbahnebenen durch eine Isolationslage (190A, 190B, 190C, 190D) gegeneinander isoliert sind;
**dadurch gekennzeichnet, dass**
zwischen einer ersten äußeren Isolationslage (190A) und einer zweiten äußeren Isolationslage (190D) ein thermisch leitfähiges Element (300) angeordnet ist;
wobei das thermisch leitfähige Element (300) Keramik aufweist und hochspannungsisolierend ausgeführt ist.

2. Leiterplatte (100) nach Anspruch 1,
wobei das thermisch leitfähige Element (300) Aluminiumnitrid aufweist.

3. Leiterplatte (100) nach Anspruch 1 oder 2,
wobei das thermisch leitfähige Element (300) elektrisch isolierend ausgeführt ist.

4. Leiterplatte (100) nach einem der vorhergehenden Ansprüche,
wobei das thermisch leitfähige Element (300) in einer Ausnehmung einer Isolationslage angeordnet ist.

5. Leiterplatte (100) nach einem der vorhergehenden Ansprüche,
wobei eine erste Oberfläche (302) des thermisch leitfähigen Elementes (300) in Tiefenrichtung (104) der Leiterplatte an eine erste Leiterbahnebene angrenzt.

6. Leiterplatte (100) nach einem der vorhergehenden Ansprüche,
wobei eine zweite Oberfläche (304) des thermisch leitfähigen Elementes (300) in Tiefenrichtung (104) der Leiterplatte an eine zweite Leiterbahnebene angrenzt.

7. Leiterplatte (100) nach einem der vorhergehenden Ansprüche,
wobei das thermisch leitfähige Element (300) sich in Tiefenrichtung (104) der Leiterplatte über mehr als eine Isolationslage erstreckt.

8. Elektrische Komponente zur Verwendung in einem Satelliten, aufweisend
eine Leiterplatte (100) nach einem der Ansprüche 1 bis 7; und
ein elektrisches Bauelement (200), welches mit einer Bestückungslage (110) der Leiterplatte (100) mechanisch und elektrisch gekoppelt ist;
wobei das thermisch leitfähige Element (300) so angeordnet ist, dass es das elektrische Bauelement (200) in Längsrichtung (102) der Leiterplatte überlappt.

9. Elektrische Komponente nach Anspruch 8,
wobei das thermisch leitfähige Element (300) so angeordnet ist, dass es das elektrische Bauelement (200) in Querrichtung der Leiterplatte überlappt.

10. Elektrische Komponente nach Anspruch 8 oder 9,
weiterhin aufweisend ein thermisches Kopplungselement (210), welches mit einer Außenlage (130) der Leiterplatte thermisch gekoppelt ist und ausgeführt ist, Wärme von der Leiterplatte abzuführen;
wobei das thermisch leitfähige Element (300) so angeordnet ist, dass es das thermische Kopplungselement (200) in Längsrichtung (102) der Leiterplatte überlappt.

## Claims

1. Printed circuit board (100) for use in high-voltage installations and under vacuum, which printed circuit board is designed to be fitted with electrical components (200), the printed circuit board having:
a plurality of conductor track planes (110, 120, 130) which are arranged one above the other;
wherein in each case two adjacent conductor track planes are insulated from one another by an insulation layer (190A, 190B, 190C, 190D);
**characterized in that**
a thermally conductive element (300) is arranged between a first outer insulation layer (190A) and a second outer insulation layer (190D);
wherein the thermally conductive element (300) comprises ceramic and is of high-voltage-insulating design.

2. Printed circuit board (100) according to Claim 1,
wherein the thermally conductive element (300) comprises aluminium nitride.

3. Printed circuit board (100) according to Claim 1 or 2,
wherein the thermally conductive element (300) is of electrically insulating design.

4. Printed circuit board (100) according to one of the preceding claims,
wherein the thermally conductive element (300) is arranged in a recess of an insulation layer.

5. Printed circuit board (100) according to one of the preceding claims,
wherein a first surface (302) of the thermally conductive element (300) adjoins a first conductor track plane in the depth direction (104) of the printed circuit board.

6. Printed circuit board (100) according to one of the preceding claims,
wherein a second surface (304) of the thermally conductive element (300) adjoins a second conductor track plane in the depth direction (104) of the printed circuit board.

7. Printed circuit board (100) according to one of the preceding claims,
wherein the thermally conductive element (300) extends over more than one insulation layer in the depth direction (104) of the printed circuit board.

8. Electrical component for use in a satellite, having a printed circuit board (100) according to one of Claims 1 to 7; and
an electrical component (200) which is mechanically and electrically coupled to a mounting layer (110) of the printed circuit board (100);
wherein the thermally conductive element (300) is arranged such that it overlaps the electrical component (200) in the longitudinal direction (102) of the printed circuit board.

9. Electrical component according to Claim 8,
wherein the thermally conductive element (300) is arranged such that it overlaps the electrical component (200) in the transverse direction of the printed circuit board.

10. Electrical component according to Claim 8 or 9, further having a thermal coupling element (210) which is thermally coupled to an outer layer (130) of the printed circuit board and is designed to dissipate heat from the printed circuit board;
wherein the thermally conductive element (300) is arranged such that it overlaps the thermal coupling element (200) in the longitudinal direction (102) of the printed circuit board.

## Revendications

1. Carte de circuit imprimé (100) destinée à être utilisée dans des installations à haute tension et sous vide, qui est conçue pour être équipée de composants électriques (200), la carte de circuit imprimé comprenant :
une pluralité de plans de pistes conductrices (110, 120, 130) disposés les uns au-dessus des autres ;
dans laquelle deux plans de pistes conductrices adjacents sont respectivement isolés l'un de l'autre par une couche isolante (190A, 190B, 190C, 190D) ;
**caractérisé en ce qu'**un élément thermiquement conducteur (300) est disposé entre une première couche isolante extérieure (190A) et une seconde couche isolante extérieure (190D) ;
dans laquelle l'élément thermiquement conducteur (300) comporte une céramique et est réalisé sous une forme isolante à haute tension.

2. Carte de circuit imprimé (100) selon la revendication 1,
dans laquelle l'élément thermiquement conducteur (300) comprend du nitrure d'aluminium.

3. Carte de circuit imprimé (100) selon la revendication 1 ou 2,
dans laquelle l'élément thermiquement conducteur (300) est réalisé sous une forme électriquement isolante.

4. Carte de circuit imprimé (100) selon l'une des revendications précédentes,
dans laquelle l'élément thermiquement conducteur (300) est disposé dans un évidement d'une couche isolante.

5. Carte de circuit imprimé (100) selon l'une des revendications précédentes,
dans laquelle une première surface (302) de l'élément thermiquement conducteur (300) est adjacente à un premier plan de pistes conductrices dans la direction de la profondeur (104) de la carte de circuit imprimé.

6. Carte de circuit imprimé (100) selon l'une des revendications précédentes,
dans laquelle une seconde surface (304) de l'élément thermiquement conducteur (300) est adjacente à un second plan de pistes conductrices dans la direction de la profondeur (104) de la carte de circuit imprimé.

7. Carte de circuit imprimé (100) selon l'une des revendications précédentes,
dans laquelle l'élément thermiquement conducteur (300) s'étend sur plus d'une couche isolante dans la direction de la profondeur (104) de la carte de circuit imprimé.

8. Composant électrique destiné à être utilisé dans un satellite, comportant
une carte de circuit imprimé (100) selon l'une des revendications 1 à 7 ; et
un composant électrique (200) qui est couplé mécaniquement et électriquement à une couche de montage (110) de la carte de circuit imprimé (100) ;
dans lequel l'élément thermiquement conducteur (300) est disposé de manière à chevaucher le composant électrique (200) dans la direction longitudinale (102) de la carte de circuit imprimé.

9. Composant électrique selon la revendication 8, dans lequel l'élément thermiquement conducteur (300) est disposé de manière à chevaucher le composant électrique (200) dans la direction transversale de la carte de circuit imprimé.

10. Composant électrique selon la revendication 8 ou 9,
comprenant en outre un élément de couplage thermique (210) couplé thermiquement à une couche extérieure (130) de la carte de circuit imprimé et conçu pour dissiper la chaleur de la carte de circuit imprimé ;
dans lequel l'élément thermiquement conducteur (300) est disposé de manière à chevaucher l'élément de couplage thermique (200) dans la direction longitudinale (102) de la carte de circuit imprimé.
